# EUROPEAN PATENT APPLICATION

(11) **EP 4 213 216 A1**
(43) Date of publication of application: **19.07.2023**
(21) Application number: 22158372.7
(22) Date of filing: 24.02.2022
(51) Int. Cl.: H01L 29/778, H01L 21/337, H01L 23/29, H01L 23/31, H01L 29/10, H01L 29/417, H01L 29/06, H01L 29/20

(54) **HIGH ELECTRON MOBILITY TRANSISTOR AND METHODS FOR FABRICATING THE SAME**

(30) Priority: 14.01.2022 CN 202210041542
(71) Applicant: United Microelectronics Corp., Hsin-Chu City 300 (TW)
(72) Inventor: YANG, Po-Yu, 300 Hsinchu City (TW)
(74) Representative: Isarpatent

(57) **Abstract**

A method for fabricating a high electron mobility transistor (HEMT) includes the steps of first forming a buffer layer (14) on a substrate (12), forming a barrier layer (16) on the buffer layer, forming a p-type semiconductor layer (18) on the barrier layer, forming a first dielectric layer (22) having a negative charge region (30) adjacent to one side of the p-type semiconductor layer, and then forming a second dielectric layer (22) having a positive charge region (24) adjacent to another side of the p-type semiconductor layer.

## Description

### Background of the Invention

### 1. Field of the Invention

The invention relates to a high electron mobility transistor (HEMT) and methods for fabricating the same.

### 2. Description of the Prior Art

High electron mobility transistor (HEMT) fabricated from GaN-based materials have various advantages in electrical, mechanical, and chemical aspects of the field. For instance, advantages including wide band gap, high break down voltage, high electron mobility, high elastic modulus, high piezoelectric and piezoresistive coefficients, and chemical inertness. All of these advantages allow GaN-based materials to be used in numerous applications including high intensity light emitting diodes (LEDs), power switching devices, regulators, battery protectors, display panel drivers, and communication devices.

### Summary of the Invention

According to an embodiment of the present invention, a method for fabricating a high electron mobility transistor (HEMT) includes the steps of first forming a buffer layer on a substrate, forming a barrier layer on the buffer layer, forming a p-type semiconductor layer on the barrier layer, forming a first layer having a negative charge region adjacent to one side of the p-type semiconductor layer, and then forming a second layer having a positive charge region adjacent to another side of the p-type semiconductor layer.

According to another aspect of the present invention, a high electron mobility transistor (HEMT) includes a buffer layer on a substrate, a barrier layer on the buffer layer, a p-type semiconductor layer on the barrier layer, a first layer having a negative charge region adjacent to one side of the p-type semiconductor layer, and a second layer having a first positive charge region adjacent to another side of the p-type semiconductor layer.

According to invention further example of the disclosure, a high electron mobility transistor (HEMT) includes a buffer layer on a substrate, a barrier layer on the buffer layer, a p-type semiconductor layer on the barrier layer, a first layer having a negative charge region adjacent to two sides of the p-type semiconductor layer, and a second layer having a positive charge region on the first layer.

These and other objectives of the present invention will no doubt become obvious to those of ordinary skill in the art after reading the following detailed description of the preferred embodiment that is illustrated in the various figures and drawings.

### Brief Description of the Drawings

Figs. 1-2 illustrate a method for fabricating a HEMT according to an embodiment of the present invention.
Figs. 3-7 illustrate a method for fabricating a HEMT according to an embodiment of the present invention.
Fig. 8 illustrates a structural view of a HEMT according to an embodiment of the present invention.
Figs. 9-11 illustrate a method for fabricating a HEMT according to an example of the present disclosure.

### Detailed Description

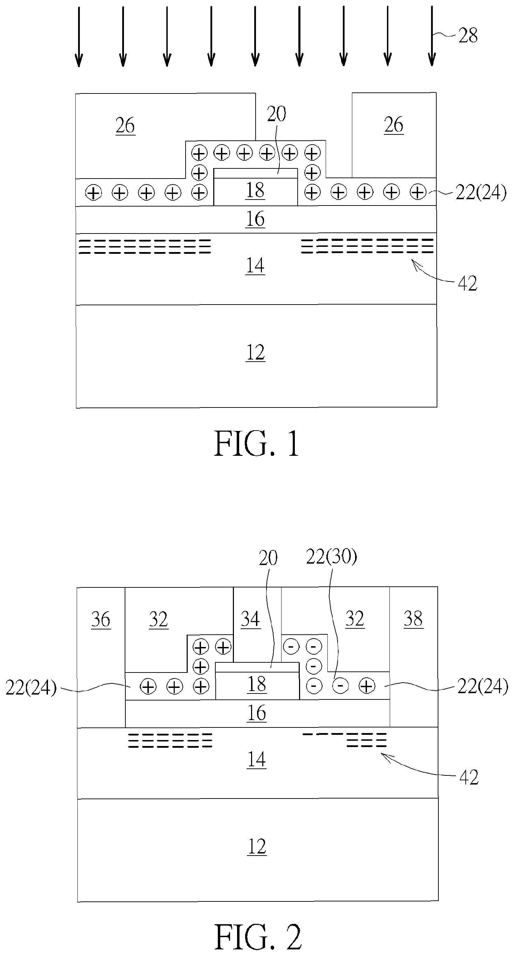

Referring to Figs. 1-2, Figs. 1-2 illustrate a method for fabricating a HEMT according to an embodiment of the present invention. As shown in Fig. 1, a substrate 12 such as a substrate made from silicon, silicon carbide, or aluminum oxide (or also referred to as sapphire) is provided, in which the substrate 12 could be a single-layered substrate, a multi-layered substrate, gradient substrate, or combination thereof. According to other embodiment of the present invention, the substrate 12 could also include a silicon-on-insulator (SOI) substrate.

Next, a selective nucleation layer (not shown) and a buffer layer 14 are formed on the substrate 12. According to an embodiment of the present invention, the nucleation layer 14 preferably includes aluminum nitride (AlN) and the buffer layer 14 is preferably made of III-V semiconductors such as gallium nitride (GaN), in which a thickness of the buffer layer 14 could be between 0.5 microns to 10 microns. According to an embodiment of the present invention, the formation of the buffer layer 14 on the substrate 12 could be accomplished by a molecular-beam epitaxy (MBE) process, a metal organic chemical vapor deposition (MOCVD) process, a chemical vapor deposition (CVD) process, a hydride vapor phase epitaxy (HVPE) process, or combination thereof.

Next, a selective unintentionally doped (UID) buffer layer (not shown) could be formed on the surface of the buffer layer 14. In this embodiment, the UID buffer layer could be made of III-V semiconductors such as gallium nitride (GaN) or more specifically unintentionally doped GaN. According to an embodiment of the present invention, the formation of the UID buffer layer on the buffer layer 14 could be accomplished by a molecular-beam epitaxy (MBE) process, a metal organic chemical vapor deposition (MOCVD) process, a chemical vapor deposition (CVD) process, a hydride vapor phase epitaxy (HVPE) process, or combination thereof.

Next, a barrier layer 16 is formed on the surface of the UID buffer layer or buffer layer 14. In this embodiment, the barrier layer 16 is preferably made of III-V semiconductor such as n-type or n- graded aluminum gallium nitride (AlₓGa₁₋ₓN), in which 0<x<1, the barrier layer 16 preferably includes an epitaxial layer formed through epitaxial growth process, and the barrier layer 16 could include dopants such as silicon or germanium. Similar to the buffer layer 14, the formation of the barrier layer 16 on the buffer layer 14 could be accomplished by a molecular-beam epitaxy (MBE) process, a metal organic chemical vapor deposition (MOCVD) process, a chemical vapor deposition (CVD) process, a hydride vapor phase epitaxy (HVPE) process, or combination thereof.

Next, a p-type semiconductor layer 18 and a passivation layer 20 are formed on the barrier layer 16, and a photo-etching process is conducted to remove part of the passivation layer 20 and part of the p-type semiconductor layer 18. In this embodiment, the p-type semiconductor layer 18 is a III-V compound semiconductor layer preferably including p-type GaN (pGaN) and the formation of the p-type semiconductor layer 18 on the barrier layer 16 could be accomplished by a molecular-beam epitaxy (MBE) process, a metal organic chemical vapor deposition (MOCVD) process, a chemical vapor deposition (CVD) process, a hydride vapor phase epitaxy (HVPE) process, or combination thereof. The passivation layer 20 preferably includes metal nitride such as titanium nitride (TiN), but not limited thereto.

Typically, a heterojunction is formed at the interface between the buffer layer 14 and barrier layer 16 as a result of the bandgap difference between the two layers. Essentially a quantum well is formed in the banding portion of the conduction band of the heterojunction to constrain the electrons generated by piezoelectricity so that a channel region or two-dimensional electron gas (2DEG) 42 is formed at the junction between the buffer layer 14 and barrier layer 16 to form conductive current.

Next, a dielectric layer 22 is formed on the passivation layer 20 to cover the surface of the barrier layer 16, in which the dielectric layer 22 preferably includes an oxygen-containing or oxygen-based dielectric layer. For instance, the dielectric layer 22 could include aluminum oxide (Al₂O₃), hafnium oxide (HfO₂), or silicon oxide (SiO₂). Viewing from another perspective, the dielectric layer 22 preferably includes an immobile positive charge region 24 and the charge of the positive charge region 24 is evenly distributed throughout the entire dielectric layer 22. In other word, the dielectric layer 22 disposed on left side of the p-type semiconductor layer 18, directly on top of the p-type semiconductor layer 18, and on right side of the p-type semiconductor layer 18 all include the positive charge region 24.

Next, as shown in Figs. 1-2, a patterned mask 26 such as a patterned resist is formed on the dielectric layer 22, in which the patterned mask 26 includes an opening exposing the surface of the dielectric layer 22 adjacent to one side of the p-type semiconductor layer 18. Next, an ion implantation process 28 is conducted by using the patterned mask 26 as mask to implant ions carrying negative charges such as fluorine ions into the dielectric layer 22 adjacent to one side of the p-type semiconductor layer 18 for forming a negative charge region 30. It should be noted that the negative charge region 30 formed at this stage preferably lowers the density of the 2DEG 42 directly underneath the negative charge region 30 in the channel region so that the density of 2DEG 42 directly under the negative charge region 30 is slightly lower than the density of 2DEG 42 directly under the positive charge region 24 on adjacent two sides.

Next, a dielectric layer 32 made of silicon oxide is formed on the dielectric layer 22, and then a gate electrode 34 is formed on the passivation layer 20 and a source electrode 36 and drain electrode 38 are formed adjacent to two sides of the gate electrode 34. In this embodiment, the formation of the gate electrode 34, the source electrode 36, and the drain electrode 38 could be accomplished by first conducting a photo-etching process to remove part of the dielectric layer 32 and part of the dielectric layer 22 directly on top of the p-type semiconductor layer 18 for forming a recess (not shown), forming the gate electrode 34 in the recess, removing part of the dielectric layers 22, 32 and part of the barrier layer 16 adjacent to two sides of the gate electrode 34 for forming two recesses, and then forming the source electrode 36 and drain electrode 38 in the two recesses.

In this embodiment, the gate electrode 34, the source electrode 36, and the drain electrode 38 are preferably made of metal, in which the gate electrode 34 is preferably made of Schottky metal while the source electrode 36 and the drain electrode 38 are preferably made of ohmic contact metals. According to an embodiment of the present invention, each of the gate electrode 34, source electrode 36, and drain electrode 38 could include gold (Au), Silver (Ag), platinum (Pt), titanium (Ti), aluminum (Al), tungsten (W), palladium (Pd), or combination thereof. Preferably, it would be desirable to conduct an electroplating process, sputtering process, resistance heating evaporation process, electron beam evaporation process, physical vapor deposition (PVD) process, chemical vapor deposition (CVD) process, or combination thereof to form conductive materials in the aforementioned recesses, and then pattern the electrode materials through one or more etching processes to form the gate electrode 34, source electrode 36, and the drain electrode 38. This completes the fabrication of a HEMT according to an embodiment of the present invention.

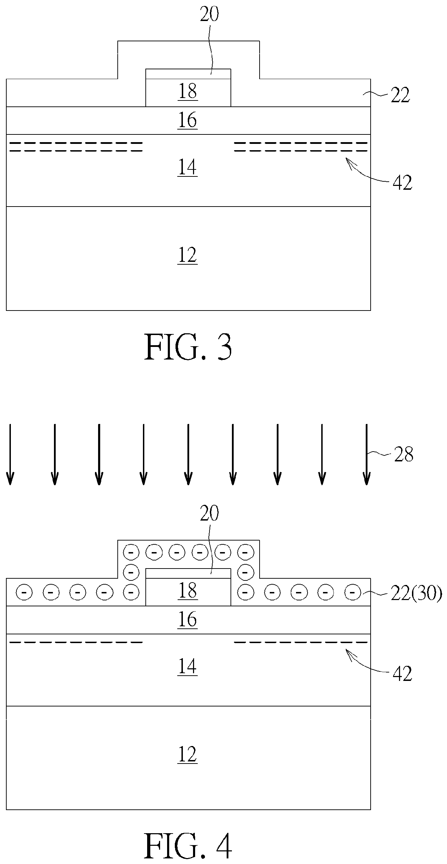

Referring to Figs. 3-7, Figs. 3-7 illustrate a method for fabricating a HEMT according to an embodiment of the present invention. For simplicity purpose, elements from the aforementioned embodiments are labeled with same numberings. As shown in Fig. 3, after forming the buffer layer 14 and barrier layer 16 on the substrate 12 as disclosed in the aforementioned embodiment, a p-type semiconductor layer 18 and a passivation layer 20 are formed on the barrier layer 16, a photo-etching process is conducted to remove part of the passivation layer 20 and part of the p-type semiconductor layer 18, and a dielectric layer 22 is formed on the patterned passivation layer 20 and p-type semiconductor layer 18. Similar to the aforementioned embodiment, the p-type semiconductor layer 18 is a III-V compound semiconductor layer preferably including p-type GaN (pGaN) and the formation of the p-type semiconductor layer 18 on the barrier layer 16 could be accomplished by a molecular-beam epitaxy (MBE) process, a metal organic chemical vapor deposition (MOCVD) process, a chemical vapor deposition (CVD) process, a hydride vapor phase epitaxy (HVPE) process, or combination thereof. The passivation layer 20 preferably includes metal nitride such as titanium nitride (TiN), but not limited thereto. It should be noted that the dielectric layer 22 formed at this stage preferably includes a nitrogen-containing layer such as a dielectric layer made of SiN.

Next, as shown in Fig. 4, an ion implantation process 28 is conducted to implant ions carrying negative charges such as fluorine ions into the dielectric layer 22 for forming a negative charge region 30. Since no patterned mask is formed at this stage during the ion implantation process 28, the ions are implanted entirely into the dielectric layer 22 so that the negative charge region 30 is evenly spread out throughout the entire dielectric layer 22. It should be noted that the negative charge region 30 formed at this stage preferably lowers the density of 2DEG 42 in the channel region underneath so that the density of 2DEG 42 under the negative charge region 30 is slightly lower than the density of 2DEG 42 shown in Fig. 3 having no negative charge region.

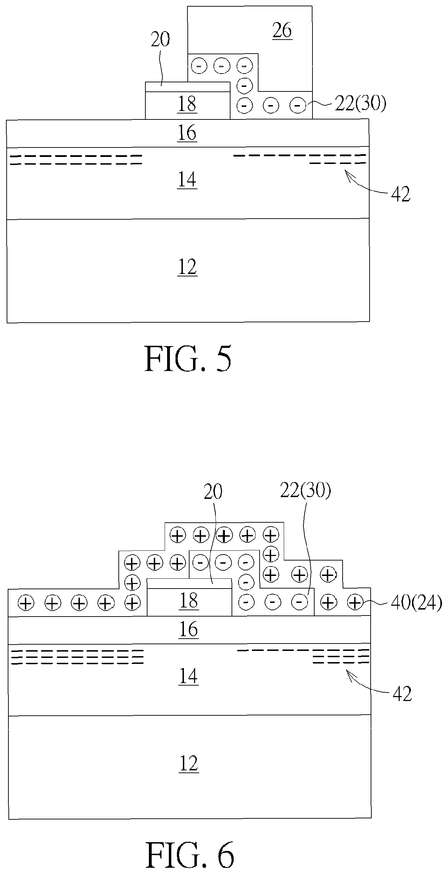

Next, as shown in Fig. 5, a patterned mask 26 such as patterned resist is formed on the dielectric layer 22, and then an etching process is conducted by using the patterned mask 26 as mask to remove part of the dielectric layer 22 so that the remaining dielectric layer 22 carrying negative charge covers the top surface of part of the passivation layer 20 and the surface of barrier layer 16 adjacent to one side of the p-type semiconductor layer 18. Since part of the dielectric layer 22 carrying negative charge region 30 is removed, the density of 2DEG 42 directly under the negative charge region 30 is slightly lower than the density of 2DEG 42 on adjacent two sides having no negative charge region 30.

Next, as shown in Fig. 6, after removing the patterned mask 26, another dielectric layer 40 is formed on the barrier layer 16, the passivation layer 20, and also the surface of the dielectric layer 22, in which the dielectric layer 40 includes a positive charge region 24 without conducting any extra ion implantation process. In this embodiment, the dielectric layer 40 preferably includes an oxygen-containing or oxygen-based dielectric layer including but not limited to for example aluminum oxide (Al₂O₃), hafnium oxide (HfO₂), or silicon oxide (SiO₂). Viewing from another perspective, the dielectric layer 40 preferably includes an immobile positive charge region 24 and the charge of the positive charge region 24 is evenly distributed throughout the entire dielectric layer 40. In other word, the dielectric layer 40 disposed on left side of the p-type semiconductor layer 18, directly on top of the p-type semiconductor layer 18, and on right side of the p-type semiconductor layer 18 all include the positive charge region 24. Since the positive charge region 24 increases the density of 2DEG 42 directly underneath, the density of 2DEG 42 directly under the positive charge region 24 at this stage is greater than the density of 2DEG 42 directly under the no negative charge region 30 or the 2DEG 42 adjacent to two sides of the negative charge region 30 shown in Fig. 5. Meanwhile, the density of 2DEG 42 directly under the negative charge region 30 in Fig. 6 is also substantially lower than the density of 2DEG 42 directly under the positive charge region 24 on two adjacent sides.

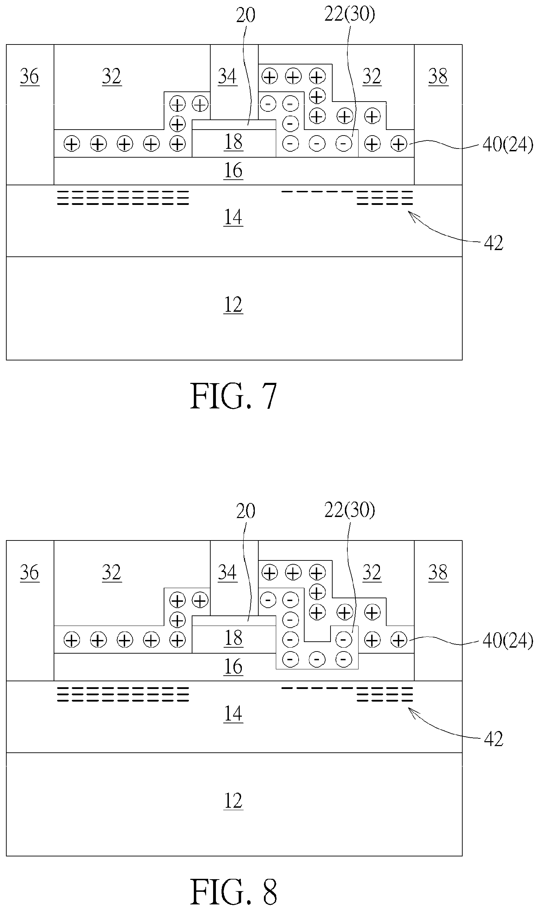

Next, as shown in Fig. 7, a dielectric layer 32 made of silicon oxide is formed on the dielectric layer 40, and then a gate electrode 34 is formed on the passivation layer 20 and a source electrode 36 and drain electrode 38 are formed adjacent to two sides of the gate electrode 34. In this embodiment, the formation of the gate electrode 34, the source electrode 36, and the drain electrode 38 could be accomplished by first conducting a photo-etching process to remove part of the dielectric layer 32 and part of the dielectric layers 22, 40 directly on top of the p-type semiconductor layer 18 for forming a recess (not shown), forming the gate electrode 34 in the recess, removing part of the dielectric layers 32, 40 and part of the barrier layer 16 adjacent to two sides of the gate electrode 34 for forming two recesses, and then forming the source electrode 36 and drain electrode 38 in the two recesses. It should be noted that during the formation of the gate electrode 34 at this stage, the dielectric layer 40 is divided into two portions on two sides of the gate electrode 34 while sidewall of the dielectric layer 40 on the right is aligned with sidewall of the dielectric layer 22 underneath.

Referring to Fig. 8, Fig. 8 illustrates a structural view of a HEMT according to an embodiment of the present invention. As shown in Fig. 8, in contrast to forming the dielectric layer 22 directly on the passivation layer 20 and p-type semiconductor layer 18 as soon as the passivation layer 20 and p-type semiconductor layer 18 are patterned, it would also be desirable to conduct an extra etching process for removing part of the barrier layer 16 adjacent to one side of the p-type semiconductor 18 for forming a trench (not shown), remove the patterned mask, and then form the dielectric layer 22 made of silicon oxide on the barrier layer 16 and passivation layer 20 while filling the trench in the barrier layer 16.

Since part of the barrier layer 16 adjacent to one side such as right side of the p-type semiconductor layer 18 is removed, the bottom surface of the dielectric layer 22 filled into the trench would be slightly lower than the top surface of the barrier layer 16. Next, processes conducted in Figs. 4-7 could be carried out to first conduct an ion implantation process for implanting ions with negative charge such as fluorine ions into the dielectric layer 22 for forming a negative charge region 30, conduct an etching process by using a patterned mask to remove part of the dielectric layer 22, form another dielectric layer 40 containing oxygen on the barrier layer 16 and passivation layer 20 and covering the surface of the dielectric layer 22, form a dielectric layer 32 made of silicon oxide ion the dielectric layer 40, and then form a gate electrode 34 on the p-type semiconductor layer 18 and a source electrode 36 and drain electrode 38 adjacent to two sides of the gate electrode 34.

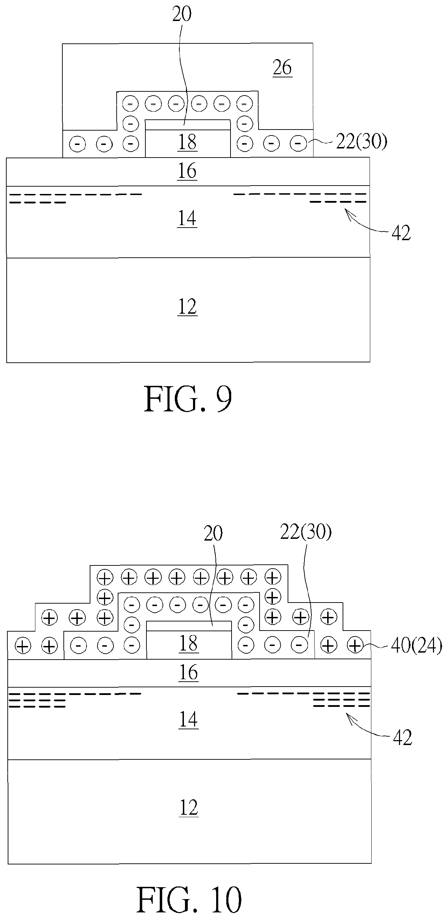

Referring to Figs. 9-11, Figs. 9-11 illustrate a method for fabricating a HEMT according to an example of the present disclosure. As shown in Fig. 9, processes in Figs. 3-4 could be first carried out form a dielectric layer 22 on the patterned passivation layer 20 and p-type semiconductor layer 18, and then conduct an ion implantation process to implant ions carrying negative charges such as fluorine ions into the dielectric layer 22 for forming a negative charge region 30.

Next, a patterned mask 26 such as patterned resist is formed on the dielectric layer 22, and then an etching process is conducted by using the patterned mask 26 as mask to remove part of the dielectric layer 22 for exposing the surface of the barrier layer 16 underneath. It should be noted that in contrast to the patterned mask 26 shown in Fig. 5 only covers the dielectric layer 22 directly on top of part of the p-type semiconductor layer 18 and the dielectric layer 22 adjacent to one side of the p-type semiconductor layer 18, the patterned mask 26 formed at this stage preferably covers the dielectric layer 22 above all of the p-type semiconductor layer 18 and the dielectric layer 22 adjacent to two sides of the p-type semiconductor layer 18. This exposes the dielectric layer 22 surface adjacent to two sides of the p-type semiconductor layer 18 so that when the etching process is conducted, part of the dielectric layer 22 adjacent to two sides of the p-type semiconductor layer 18 or passivation layer 20 is removed to expose the barrier layer 16 surface underneath. Similar to the embodiment shown in Fig. 5, since part of the dielectric layer 22 carrying negative charge region 30 is removed, the density of 2DEG 42 directly under the negative charge region 30 at this stage is slightly lower than the density of 2DEG 42 under no negative charge region 30.

Next, as shown in Fig. 10, the patterned mask 26 is removed to expose the dielectric layer 22, and another dielectric layer 40 is formed on the barrier layer 16, the passivation layer 20, and also the surface of the dielectric layer 22, in which the dielectric layer 40 includes a positive charge region 24 without conducting any extra ion implantation process. In this example, the dielectric layer 40 preferably includes an oxygen-containing or oxygen-based dielectric layer including but not limited to for example aluminum oxide (Al₂O₃), hafnium oxide (HfO₂), or silicon oxide (SiO₂). Viewing from another perspective, the dielectric layer 40 preferably includes an immobile positive charge region 24 and the charge of the positive charge region 24 is evenly distributed throughout the entire dielectric layer 40. In other word, the dielectric layer 40 disposed on left side of the p-type semiconductor layer 18, directly on top of the p-type semiconductor layer 18, and on right side of the p-type semiconductor layer 18 all include the positive charge region 24. Since the positive charge region 24 increases the density of 2DEG 42 directly underneath, the density of 2DEG 42 directly under the positive charge region 24 at this stage is greater than the density of 2DEG 42 directly under the no negative charge region 30 or the 2DEG 42 adjacent to two sides of the negative charge region 30 as shown in Fig. 9. Meanwhile, the density of 2DEG 42 directly under the negative charge region 30 in Fig. 10 is also substantially lower than the density of 2DEG 42 directly under the positive charge region 24 on two adjacent sides.

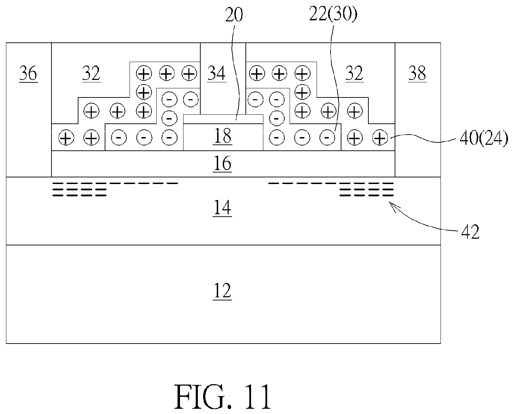

Next, as shown in Fig. 11, a dielectric layer 32 made of silicon oxide is formed on the dielectric layer 40, and then a gate electrode 34 is formed on the passivation layer 20 and a source electrode 36 and drain electrode 38 are formed adjacent to two sides of the gate electrode 34. In this embodiment, the formation of the gate electrode 34, the source electrode 36, and the drain electrode 38 could be accomplished by first conducting a photo-etching process to remove part of the dielectric layer 32 and part of the dielectric layers 22, 40 directly on top of the p-type semiconductor layer 18 for forming a recess (not shown), forming the gate electrode 34 in the recess, removing part of the dielectric layers 32, 40 and part of the barrier layer 16 adjacent to two sides of the gate electrode 34 for forming two recesses, and then forming the source electrode 36 and drain electrode 38 in the two recesses. It should be noted that according to another embodiment of the present invention, it would be desirable to combine the processes conducted in Figs. 8 and 11 by conducting an extra photo-etching process such as using another patterned mask (not shown) to remove part of the barrier layer 16 adjacent to two sides of the p-type semiconductor layer 18 for forming two trenches, removing the patterned mask, and then forming the dielectric layer 22 made of silicon oxide on the barrier layer 16 and passivation layer 20 while filling the two trenches in the barrier layer 16. Since part of the barrier layer 16 adjacent to two sides of the p-type semiconductor layer 18 is removed, the bottom surface of the dielectric layer 22 filled into the trenches would be slightly lower than the top surface of the barrier layer 16, which is also within the scope of the present invention.

Conventionally, ion implantation process is often conducted to implant fluorine ions into the barrier layer made of AlₓGa₁₋ₓN for lowering electrical field on the drain terminal during fabrication of HEMT. This approach however creates distribution vacancy and easily induces damages to the channel region or 2DEG. To resolve this issue, the present invention first forms a p-type semiconductor layer such as pGaN and an optional passivation layer on the barrier layer and then forms at least a dielectric layer on the p-type semiconductor layer and the passivation layer, in which the dielectric layer on one side of the p-type semiconductor layer includes a positive charge region while the dielectric layer on another or opposite side of the p-type semiconductor layer includes a negative charge region and the negative charge region preferably not contacting the source electrode and/or drain electrode directly. By using the above approach to form an immobile negative charge region and an immobile positive charge region in dielectric material adjacent to two sides of the p-type semiconductor layer or gate electrode, it would be desirable to improve breakdown voltage of the device substantially. Preferably, the dielectric portion including the immobile negative charge region could effectively lower high electrical field on the edge of drain terminal while the dielectric portion including the immobile positive charge region could lower on-resistance (Ron) and increase density of the 2DEG.

Those skilled in the art will readily observe that numerous modifications and alterations of the device and method may be made while retaining the teachings of the invention.

## Claims

1. A method for fabricating a high electron mobility transistor, HEMT, comprising:
forming a buffer layer (14) on a substrate (12);
forming a barrier layer (16) on the buffer layer (14);
forming a p-type semiconductor layer (18) on the barrier layer (16);
forming a first layer (22) having a negative charge region (30) adjacent to one side of the p-type semiconductor layer (18); and
forming a second layer (22; 40) having a positive charge region (24) adjacent to another side of the p-type semiconductor layer (18).

2. The method of claim 1, further comprising:
forming a passivation layer (20) on the p-type semiconductor layer (18);
forming a dielectric layer (22) as first and second layer on the passivation layer (20), the dielectric layer (22) comprising the positive charge region (24);
performing an implantation process to form the negative charge region (30);
forming a gate electrode (34) on the p-type semiconductor layer (18); and
forming a source electrode (36) and a drain electrode (38) adjacent to two sides of the gate electrode (34).

3. The method of claim 2, further comprising performing the implantation process to implant fluorine into the first layer (22) for forming the negative charge region (30).

4. The method of claim 2 or 3, wherein the dielectric layer (22) comprises an oxygen-based dielectric layer.

5. The method of claim 1, further comprising:
forming a passivation layer (20) on the p-type semiconductor layer (18);
forming a first dielectric layer (22) on the passivation layer (20);
performing an implantation process to form the negative charge region (30);
forming a second dielectric layer (40) as the second layer on the p-type semiconductor layer (18), the second dielectric layer (40) comprising the positive charge region (24);
forming a gate electrode (34) on the p-type semiconductor layer (18); and
forming a source electrode (36) and a drain electrode (38) adjacent to two sides of the gate electrode (34).

6. The method of claim 5, wherein the first dielectric layer (22) comprises a nitrogen-containing layer.

7. The method of claim 5 or 6, wherein the second dielectric layer (40) comprises an oxygen-containing layer.

8. The method of one of the claims 5 to 7, further comprising performing the implantation process to implant fluorine into the first dielectric layer (22) for forming the negative charge region (30).

9. The method of one of the claims 5 to 8, further comprising forming a trench in the barrier layer (16) before forming the first dielectric layer (22).

10. A high electron mobility transistor, HEMT, comprising:
a buffer layer (14) on a substrate (12);
a barrier layer (16) on the buffer layer (14);
a p-type semiconductor layer (18) on the barrier layer (16);
a first layer (22) having a negative charge region (30) adjacent to one side of the p-type semiconductor layer (18); and
a second layer (22; 40) having a first positive charge region (24) adjacent to another side of the p-type semiconductor layer (18).

11. The HEMT of claim 10, further comprising:
a passivation layer (20) on the p-type semiconductor layer (18);
a gate electrode (34) on the passivation layer (20); and
a source electrode (36) and a drain electrode (38) adjacent to two sides of the gate electrode (34).

12. The HEMT of claim 10 or 11, further comprising a third layer (40) having a second positive charge region (24) on the first layer (22) and the barrier layer (16).

13. The HEMT of claim 12, wherein a sidewall of the third layer (40) is aligned with a sidewall of the first layer (22).

14. The HEMT of one of the claims 12 and 13, wherein the third layer (40) comprises an oxygen-based dielectric layer.

15. The HEMT of one of the claims 10 to 14, wherein a bottom surface of the first layer (22) is lower than a top surface of the barrier layer (16).

## Amended claims

### Amended claims in accordance with Rule 137(2) EPC.

1. A method for fabricating a high electron mobility transistor, HEMT, comprising:
forming a buffer layer (14) on a substrate (12);
forming a barrier layer (16) on the buffer layer (14);
forming a p-type semiconductor layer (18) on the barrier layer (16);
forming a first dielectric layer (22) having a negative charge region (30) adjacent to one side of the p-type semiconductor layer (18); and
forming a second dielectric layer (22, 40) having a positive charge region (24) adjacent to another side of the p-type semiconductor layer (18), wherein the second dielectric layer (22, 40) contacts a sidewall of the p-type semiconductor layer (18) directly.

2. The method of claim 1, further comprising:
forming a metal nitride passivation layer (20) on the p-type semiconductor layer (18);
forming a dielectric layer (22) as first and second dielectric layers on the metal nitride passivation layer (20), the dielectric layer (22) comprising the positive charge region (24);
performing an implantation process to form the negative charge region (30);
forming a gate electrode (34) on the metal nitride passivation layer (20); and
forming a source electrode (36) and a drain electrode (38) adjacent to two sides of the gate electrode (34).

3. The method of claim 2, further comprising performing the implantation process to implant fluorine into the first layer (22) for forming the negative charge region (30).

4. The method of claim 2 or 3, wherein the dielectric layer (22) comprises an oxygen-based dielectric layer.

5. The method of claim 1, further comprising:
forming a metal nitride passivation layer (20) on the p-type semiconductor layer (18);
forming a first dielectric layer (22) on the metal nitride passivation layer (20) and on the barrier layer (16);
performing an implantation process to form the negative charge region (30);
forming a second dielectric layer (40) as the second dielectric layer on the p-type semiconductor layer (18), the second dielectric layer (40) comprising the positive charge region (24);
forming a gate electrode (34) on the metal nitride passivation layer (20); and
forming a source electrode (36) and a drain electrode (38) adjacent to two sides of the gate electrode (34).

6. The method of claim 5, wherein the first dielectric layer (22) comprises a nitrogen-containing layer.

7. The method of claim 5 or 6, wherein the second dielectric layer (40) comprises an oxygen-containing layer.

8. The method of one of the claims 5 to 7, further comprising performing the implantation process to implant fluorine into the first dielectric layer (22) for forming the negative charge region (30).

9. The method of one of the claims 5 to 8, further comprising forming a trench in the barrier layer (16) before forming the first dielectric layer (22).

10. A high electron mobility transistor, HEMT, comprising:
a buffer layer (14) on a substrate (12);
a barrier layer (16) on the buffer layer (14);
a p-type semiconductor layer (18) on the barrier layer (16);
a first dielectric layer (22) having a negative charge region (30) adjacent to one side of the p-type semiconductor layer (18); and
a second dielectric layer (22; 40) having a first positive charge region (24) adjacent to another side of the p-type semiconductor layer (18), wherein the second dielectric layer (22, 40) contacts a sidewall of the p-type semiconductor layer (18) directly.

11. The HEMT of claim 10, further comprising:
a metal nitride passivation layer (20) on the p-type semiconductor layer (18);
a gate electrode (34) on the passivation layer (20); and
a source electrode (36) and a drain electrode (38) adjacent to two sides of the gate electrode (34).

12. The HEMT of claim 10 or 11, further comprising a third dielectric layer (40) having a second positive charge region (24) on the first dielectric layer (22) and the barrier layer (16).

13. The HEMT of claim 12, wherein a sidewall of the third dielectric layer (40) is aligned with a sidewall of the first layer (22).

14. The HEMT of one of the claims 12 and 13, wherein the third dielectric layer (40) comprises an oxygen-based dielectric layer.

15. The HEMT of one of the claims 10 to 14, wherein a bottom surface of the first dielectric layer (22) is lower than a top surface of the barrier layer (16).
